# EUROPEAN PATENT APPLICATION

(11) **EP 4 369 880 A1**
(43) Date of publication of application: **15.05.2024**
(21) Application number: 23202599.9
(22) Date of filing: 10.10.2023
(51) Int. Cl.: H05K 13/02

(54) **BATTERY FEEDER**

(30) Priority: 10.11.2022 DE 102022129785
(71) Applicant: ASMPT GmbH & Co. KG, 81379 Munich (DE)
(72) Inventor: PFEIFER, Vincent, 80333 Munich (DE)
(74) Representative: Emerson, Peter James

(57) **Abstract**

A battery for a mobile robot operative to exchange feeders with a placement machine may be exchanged by using a feeder exchange mechanism to transfer a depleted battery from the mobile robot to a battery storage.

## Description

This invention relates to a mobile robot, a battery, an SMT production line, and a method of replacing a battery.

### Background and Prior Art

The present invention relates in general to the technical field of equipping component carriers, such as printed circuit boards (PCBs), substrates or workpieces, with electronic components in a so-called surface-mount technology (SMT) process.

The production of such electronic subassemblies occurs typically with so-called placement machines, by which electronic components are removed from a component supply device in an automated manner and placed on a component carrier such as, for example, a printed circuit board. A transfer of components from the component supply device to their respective placement position occurs by means of a component handling device, for example a so-called placement head.

The most common packaging for small electronic components uses carrier tapes, sometimes referred to as "belts", into which small pockets are formed. In each of the pockets there is provided one component. Only one type of component is located within each carrier tape. To save space and for easier transport, the carrier tapes are conventionally formed as reels by winding on a spool. Typically, the tape reel is placed in a feeder module which includes drive means for driving the tape forward, such as a motor-driven pin-wheel which engages with holes provided along the length of the carrier tape, and a pick-up area or window which provides access to the components. The feeder module can be removably inserted into a placement machine.

More recently, a cartridge system has been proposed, in which a reel is placed in a passive cartridge module or cassette, which may conveniently be a relatively inexpensive plastic container or envelope of defined shape which may be easily held by a robot, which may be loaded at a central filling station and subsequently inserted into a feeder. As an alternative, if the placement machine itself is provided with tape driving mechanisms, then the cartridge module could be directly inserted into the placement machine. An example of a cartridge and feeder arrangement is described for example in DE 10 2019 127 299.8. In such systems, the feeder unit may be used to drive the carrier tape located within a cartridge unit so that components located within pockets of the carrier tape are moved to a picking region where a placement head of a placement machine can access the components. The picking region could be located within the cartridge or within the feeder, depending on the particular design.

For the operation of the placement machine it is necessary to be able to supply feeders (and / or cartridges depending on the set-up), including respective carrier tapes, to the placement machine.

Such retooling (i.e. fitting of different feeders / cartridges) is currently a manual process that requires a high level of personnel input. For some years now, considerable efforts have been made to automate material replenishment and changeover.

As specific background art may be mentioned EP3419402A1. As described in this document, an external exchanging device may be provided to transfer a feeder, which includes both feeding capability and material storage, between a storage location and an operational location, with the exchanging device operable to move along a production line with one or more placement machines parallel to the direction of workpiece throughput. The exchanging device is operative to translate along a rail mounted along the production line, and is supported by the rail (for this reason the device may be termed a "rail-guided vehicle"). Such an approach has various advantages, for example using a machine-mounted rail avoids any problems that may arise due to imperfections in the floor surface, since the exchanging device is held at a fixed vertical position relative to the placement machines, and furthermore a high level of positioning accuracy along the production line is possible. One advantage of such a system is that the rail-guided vehicle may draw power continuously from the placement machine. However, there are also various disadvantages associated with such a system. For example, it is necessary to use a dedicated exchanging device for each side of the production line, which may limit how close adjacent lines may be placed. The described system also lacks flexibility, and for example cannot manage cartridge-based feeding systems. It has been found that the system is relatively slow, and is also expensive due to the large requirement for dedicated equipment for each production line.

It has been recognised that a more flexible and potentially cheaper solution may be to equip an automatic-guided vehicle (AGV) or autonomous mobile robot (AMR) with a feeder / cartridge replacement mechanism. For convenience, throughout the rest of this document, the term "AGV" will be used to collectively refer to all such mobile robots, which are not constrained to move along rails or other set paths. As is well-known in the art per se, AGVs are generally small mobile robot devices, typically movable across a floor by means of a wheeled chassis, with at least a degree of autonomy. AGVs are available from many manufacturers (and hence relatively inexpensive and with a likelihood that a production line operator may already possess suitable AGVs), and are typically provided with an upper platform which can carry job-specific equipment. Unfortunately, the use of AGVs for feeder / cartridge changeover is problematic, due to their power requirements. In particular, they cannot draw power continuously, unless they are provided with either a contact wire contacting a power track (similarly to a tram or a dodgem car for example), or with a cable drag chain, which could obstruct other AGVs, suffer from abrasion damage, and provide trip risks for human operators. It is therefore necessary to provide the AGV with a mobile power source, in particular a rechargeable battery.

Various battery solutions are commercially available for AGVs, however these have drawbacks when seeking to automate an SMT line:

### i) Fixed battery

It is possible to provide an AGV with a fixed battery. In order to recharge the battery, the AGV must be plugged in to a charging point, meaning that either a plug has to be led to the AGV (which presents similar problems as the cable drag chains described above), or the AGV must travel to a charging station. While this option may be fully automatable, if more than one AGV needs to visit the charging station then delays will be incurred as one AGV waits for the other to complete charging. Furthermore, using short charging cycles to avoid this problem may adversely impact the life cycle of the battery.

### ii) Exchangeable battery

Alternatively, an AGV may be able to exchange a spent battery with a fully-charged battery from a battery store, and this exchange could be performed manually or automatically. Manual exchange requires operators, and so defeats the aim of factory automisation. Automatic exchange meanwhile requires a relatively expensive exchange station, including complex mechanisms for physically exchanging the batteries.

The present invention seeks to provide an automated power supply system for mobile robots, such as, but not limited to AGVs, associated with an SMT production facility, in which automatically-exchangeable batteries are used to provide power, without requiring an expensive exchange station. In accordance with the present invention, this aim is achieved by using the same exchange system used by the mobile robot to exchange feeders / cartridges for battery exchange also, thus removing the need for expensive and complex exchange mechanisms at an exchange station. In particular this may be implemented by using exchangeable batteries which are provided with the same physical interface as the feeders / cartridges carried by the mobile robot in use.

For convenience, the following terms will be used hereafter in this document with the following meanings:
"Mobile robot" will be taken mean robotic vehicles including AGVs, AMRs as well as rail-guided or other path-constrained vehicles;
"Feeder" will be taken to encompass both feeders which include tape reel storage and a driving means for advancing the carrier tape, and modular cartridge - feeder systems in which tape reel storage and driving means are located in separate interengaging cartridge and feeder parts;
X, Y and Z axes will be used as is conventional in the art, with:
   the X axis parallel to the direction of workpiece transport along a production line, increasing in the downstream direction and being substantially horizontal,
   the Y axis orthogonal to the X axis, increasing in the direction towards the placement machine and being substantially horizontal, and
   the Z axis orthogonal to the X and Y axes, being generally vertical and increasing in the upwards direction.

### Summary of the Invention

In accordance with a first aspect of the present invention there is provided a mobile robot for exchanging feeders with a placement machine, the mobile robot comprising:
a feeder store for temporarily storing feeders,
an exchange mechanism configured to transfer feeders from the feeder store to a placement machine,
a robot electrical contact for receiving electrical power from a modular battery adapted for releasable and repeatable engagement with the mobile robot,
wherein the exchange mechanism is configured to transfer the modular battery to an external battery storage.

In accordance with a second aspect of the present invention there is provided a battery specifically for providing power to a mobile robot configured to transfer feeders to a placement machine, the mobile robot comprising an elongate feeder track in which a respective feeder may be temporarily stored, wherein the battery comprises:
a battery-side engagement means configured to releasably and repeatedly engage with an elongate battery track located on the mobile robot arranged parallel to the elongate feeder track, and
a battery electrical contact for providing electrical power to the mobile robot when the battery-side engagement means is physically engaged with the elongate battery track.

In accordance with a third aspect of the present invention there is provided an SMT production line comprising:
a placement machine,
a mobile robot according to the first aspect, and
a charging station for charging a modular battery according to the second aspect for providing power to the mobile robot.

In accordance with a fourth aspect of the present invention there is provided a method of replacing a battery for a mobile robot, the mobile robot operative to exchange feeders with a placement machine and comprising:
a feeder store for temporarily storing feeders, and
an exchange mechanism configured to transfer feeders from the feeder store to a placement machine,
the method comprising the steps of:
   i) moving the mobile robot to a battery storage, and
   ii) using the exchange mechanism to transfer a depleted battery from the mobile robot to the battery storage.

Other specific aspects and features of the present invention are set out in the accompanying claims.

### Brief Description of the Drawings

The invention will now be described with reference to the accompanying drawings (not to scale), in which:
FIG. 1 schematically shows, in perspective view, a mobile robot according to an embodiment of the present invention for carrying feeders, approaching a charging station;
FIG. 2 schematically shows, in perspective view, the mobile robot of FIG. 1, approaching a different type of charging station;
FIG. 3 schematically shows, in perspective view, an expanded view of the engagement means of a feeder and a battery, in accordance with an embodiment of the present invention;
FIG. 4 schematically shows, in perspective view, the battery of FIG. 3;
FIG. 5 schematically shows, in perspective view, an expanded view of the engagement means of a feeder and a battery, in accordance with another embodiment of the present invention;
FIG. 6 schematically shows, in perspective view, the mobile robot of FIG. 1 with its exchange mechanism;
FIGs. 7A-C schematically show, from the side, the exchange mechanism of FIG. 6 in various stages of operation; and
FIG. 8 schematically shows, in perspective view, a placement machine used as a charging station.

### Detailed Description of the Preferred Embodiments of the Invention

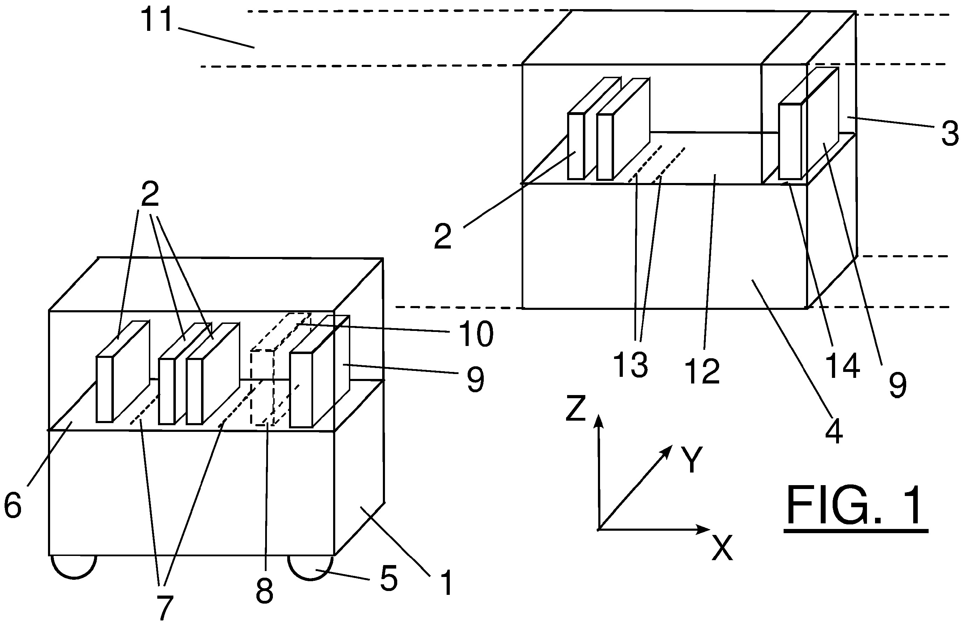

FIG. 1 schematically shows, in perspective view, a mobile robot 1 according to an embodiment of the present invention for carrying feeders 2, approaching an external battery storage, here a charging station 3 located within a line-side stock station (LSS) 4. In more detail, the mobile robot 1, which here for example only is an AGV-type mobile robot with steerable wheels 5 allowing travel in with components of horizontal motion along both the orthogonal X and Y axes shown, is provided with a table 6 which includes at least one robot feeder track 7 (here five are provided), each robot feeder track 7 being of elongate form and extending across the surface of the table 6 in parallel. As will be described in more detail below, each robot feeder track 7 is profiled to permit releasable and repeatable engagement with a feeder 2. The table 5 therefore functions as a feeder store for temporarily storing feeders 2, for example while they are being carried between the LSS 4 and a placement machine (not shown), or between a separate feeder carousel (not shown) and the LSS 4 etc. In FIG. 1, three of the five robot feeder tracks 7 have respective feeders 2 engaged therewith. In addition, the table 6 also includes at least one robot battery track 8 (here two are provided), each robot battery track 8 being of elongate form and extending across the surface of the table 6 in parallel with the robot feeder tracks 7. As will be described in more detail below, each robot battery track 8 is profiled to permit releasable and repeatable engagement with a battery 9, in particular a modular battery adapted for releasable and repeatable engagement with the mobile robot 1. In FIG. 1, one of the robot battery tracks 8 is engaged with a battery 9, the other is empty, but an outline of a battery 10 is shown where the battery 10 would be located.

As will be described in more detail below, each battery 9 may provide electrical power to the mobile robot 1 when it is located in a respective robot battery track 8. The provision of two robot battery tracks 8 is therefore advantageous, since the mobile robot 1 may draw operating power from one battery 9, while an exhausted battery is being exchanged with the charging station 3. However, this is not essential - for example, a single robot battery track 8 may be used, if the mobile robot 1 is provided with auxiliary means (not shown) to store power during battery exchange, such as a separate rechargeable battery or capacitor. Of course, greater than two robot battery tracks 8 may also be provided to offer additional power back-up, but this uses up space on the table 6 which might be better used for robot feeder tracks 7.

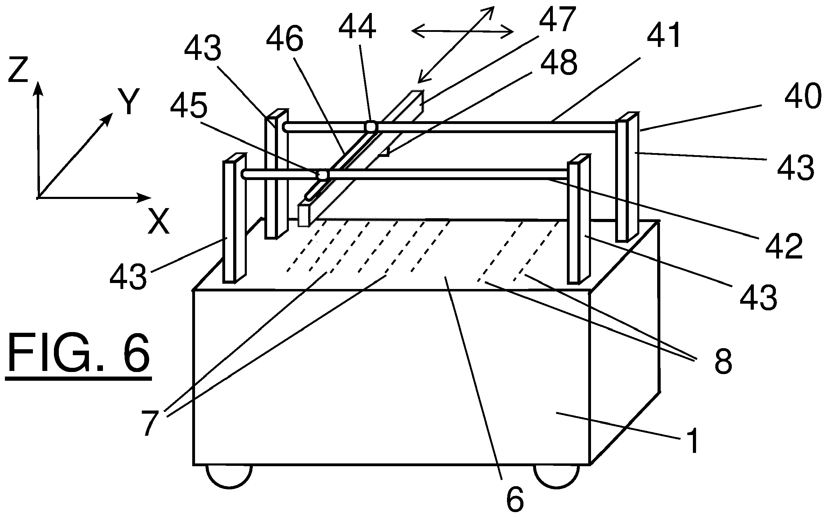

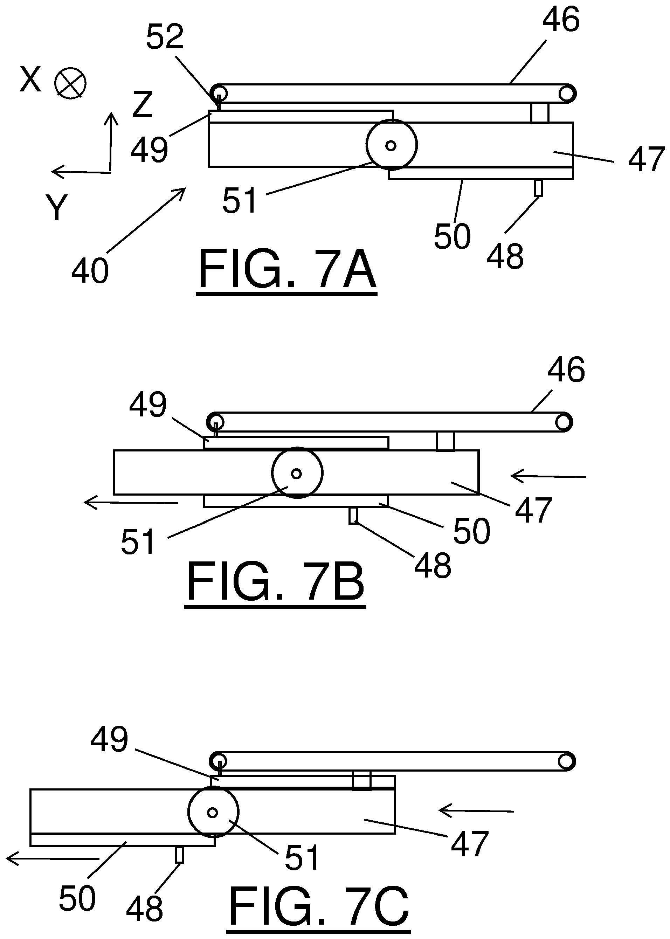

Furthermore, the mobile robot 1 is provided with an exchange mechanism configured to transfer feeders from the feeder store to a placement machine; for clarity this is not shown in FIG. 1, but is described in more details with reference to FIGs. 6 and 7A-C below.

The LSS 4 as shown in FIG. 1 is located within an SMT production line 11, which, as is well-known in the art per se, may, as the particular application requires, comprise one or more placement machines, printing machines, inspection machines, reflow ovens etc, none of which are shown for clarity. Using conventional notation, workpieces processed by the production line 11 travel along the production line 11 in the X direction shown, the Y direction is horizontal and orthogonal to the X direction and so is therefore associated with the width of the production line, while the Z direction extends vertically upwards. The LSS 4 comprises an LSS table 12 which includes at least one LSS feeder track 13 (here four are shown for the sake of example), each LSS feeder track 13 being of elongate form and extending across the surface of the LSS table 12 in parallel. Each LSS feeder track 13 is profiled to permit releasable and repeatable engagement with a feeder 2, and so has a similar profile to the robot feeder tracks 7. The LSS table 12 therefore functions as a store for temporarily storing feeders 2, for example after they have arrived from the feeder carousel and are awaiting deployment at a placement machine. The LSS feeder tracks 13 extend parallel to the Y axis from the front of the LSS 4. Therefore, when the mobile robot 1 approaches the LSS 4 in the orientation shown in FIG. 1, feeders may be exchanged between the mobile robot 1 and the LSS 4 by sliding the feeders 2 between adjacent and aligned respective robot feeder tracks 7 and LSS feeder tracks 13.

The LSS 4 also includes a battery storage, in this case a charging station 3, which comprises an LSS battery track 14 located on the LSS table 12 in a dedicated area thereof (here at the end of the LSS 4 furthest along the X axis). The LSS battery track 14 is of elongate form and extends across the surface of the LSS table 12 in parallel to the LSS feeder tracks 13. The LSS battery track 14 is profiled to permit releasable and repeatable engagement with a battery 9, and so has a similar profile to the robot battery tracks 8. The charging station 3 therefore functions as a store for temporarily storing a battery 9. While a battery 9 is stored in the charging station 3, it may be automatically recharged by the charging station 3, and for this purpose electrical contacts (not shown) may be provided proximate the LSS battery track 14 to engage with electrical contacts provided on the engaged battery 9, as will be described in further detail below.

The LSS battery track 14 extends parallel to the Y axis from the front of the LSS 4. Therefore, when the mobile robot 1 approaches the LSS 4 in the orientation shown in FIG. 1, a battery 9 may be exchanged between the mobile robot 1 and the charging station 3 by sliding the battery 9 between an adjacent and aligned respective robot battery track 8 and the LSS battery track 14.

In use, when the mobile robot 1 requires a charged battery 9 (determined for example by the use of a conventional charge monitoring system (not shown) provided on the mobile robot 1 and communicatively connected to a control system (not shown) of the mobile robot 1), the mobile robot 1 moves to the LSS 4 in the orientation shown in FIG. 1, so that the LSS battery track 14 aligns with the empty (i.e. leftmost as shown in FIG. 1) robot battery track 8. A charged battery 9 may then be transferred from the LSS battery track 14 to the empty robot battery track 8 using the mobile robot's exchange mechanism (described in more detail below). The mobile robot may then move parallel to the X axis to align the rightmost robot battery track 8 with the LSS battery track 14, in which position the exchange mechanism may slide the exhausted battery to the LSS battery track 14, where it commences recharging. The mobile robot 1 may then continue to perform other duties as required.

Although not described in detail here, it should be understood that the placement machine also comprises machine feeder tracks which extend parallel to the LSS feeder tracks 13 and are similarly profiled, and therefore feeders 2 may be exchanged between the mobile robot 1 and the placement machine by sliding the feeders 2 between adjacent and aligned respective robot feeder tracks 7 and machine feeder tracks.

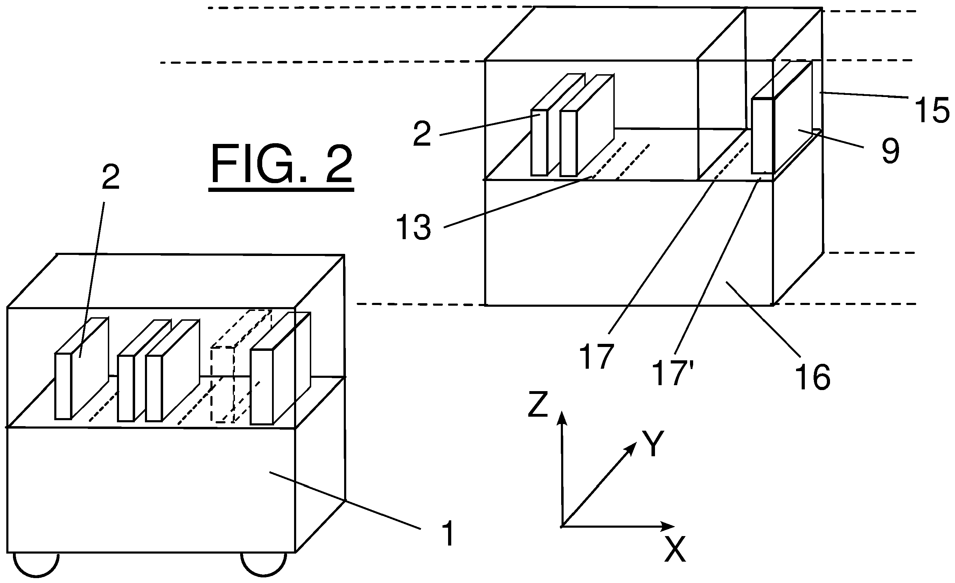

FIG. 2 schematically shows, in perspective view, the mobile robot 1 of FIG. 1, approaching a different type of charging station 15 at an LSS 16. With this charging station 15, there are two LSS battery tracks 14, 14' provided, each extending parallel to the LSS feeder tracks 13. With such a charging station, two batteries 9 may be recharged simultaneously, which may be advantageous for certain high power-usage production lines, or where more than one mobile robot 1 services that section of the production line. Of course, in alternative embodiments (not shown), yet further LSS battery tracks 14, 14' may be provided as required. However, ideally the number of LSS battery tracks 14, 14' should be minimised as far as possible, so as to maximise the space available in the LSS 16 for LSS feeder tracks 13.

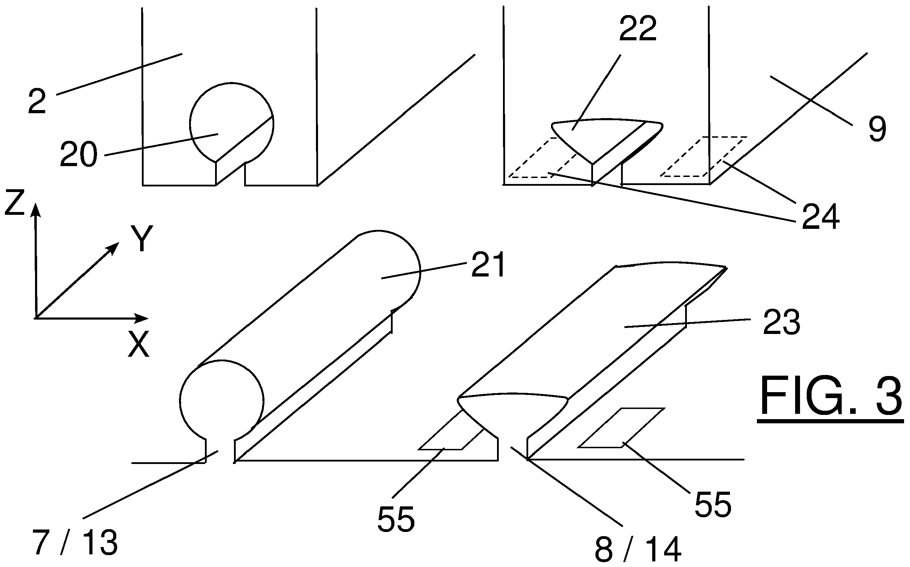

FIG. 3 schematically shows, in perspective view, an expanded view of the engagement means of a feeder 2 and a battery 9, in accordance with an embodiment of the present invention. Feeder 2 comprises a profiled feeder slot 20 formed in its base (i.e. the side at lowest Z position in use) which extends at least partially along the length (i.e. the dimension extending parallel to the Y axis in use) of the feeder 2. The profiled feeder slot 20 is dimensioned to fit snugly around a profiled feeder member 21 projecting from the upper surface of a respective robot feeder track 7 or LSS feeder track 13. It should be understood that since the profile of the robot feeder tracks 7 and LSS feeder tracks 13 are similar, the track shown could be either of the robot feeder track 7 or LSS feeder track 13, hence the labelling of this track in FIG. 3 as "7 / 13".

Similarly, battery 9 comprises a battery-side engagement means in the form of a profiled battery slot 22 formed in its base (i.e. the side at lowest Z position in use) which extends at least partially along the length (i.e. the dimension extending parallel to the Y axis in use) of the battery 9. The profiled battery slot 22 is dimensioned to fit snugly around a profiled battery member 23 projecting from the upper surface of a respective robot battery track 8 or LSS battery track 14. It should be understood that since the profile of the robot battery tracks 8 and LSS battery tracks 14 are similar, the track shown could be either of the robot battery track 8 or LSS battery track 14, hence the labelling of this track in FIG. 3 as "8 / 14".

The battery 9 comprises electrical battery contacts 24 located on the lower surface of the battery 9, adjacent the profiled battery slot 22, which may be used both to provide power to external devices, and to receive power to recharge the battery 9. Electrical track contacts 55 are provided adjacent the profiled battery member 23 in a similar relative position to the battery contacts 24, to contact with and thus receive (in the case of LSS battery track 14) or provide (in the case of robot battery track 8) electrical energy to the battery contacts 24 when the battery 9 is fully engaged with the respective battery track 8, 14.

The profiles illustrated in FIG. 3 for the battery and feeder slots are exemplary only, and many variations are possible. However, in all cases it is important that the respective battery or feeder may be repeatably and releasably engaged with the respective track by the exchange mechanism of the mobile robot 1, for example by sliding, and once physically engaged with the track, the feeder or battery is sufficiently well-retained to prevent accidental disengagement.

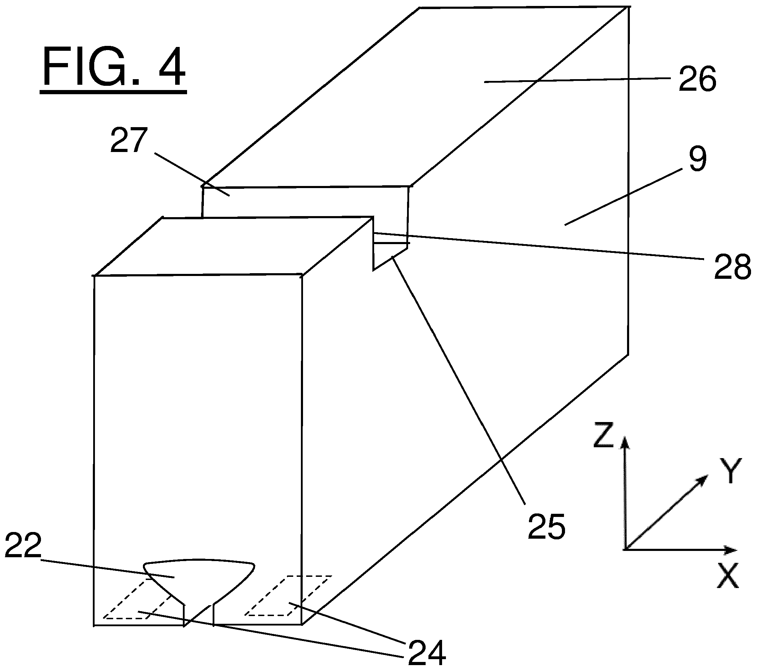

FIG. 4 schematically shows, in perspective view, the battery 9 of FIG. 3, with the profiled battery slot 22 and battery contacts 24 shown at the base of the battery 9. The battery 9 comprises an exchange member 25 for physically engaging with the exchange mechanism of the mobile robot 1, here formed as a recess in the upper surface 26 of the battery 9. The recessed form of the exchange member 25 creates two internal sidewalls 27, 28 of the recess, facing each other and spaced in the Y direction in use. These internal sidewalls 27, 28 provide purchase for the exchange mechanism so that, as described in more detail below, the exchange mechanism may push the battery 9 in the Y direction by pushing against the sidewall 27, and pull the battery 9 in the opposite direction by pulling against sidewall 28.

The exchange member 25 shown is only one of many possible designs, for example, the exchange member could comprise a projecting feature, which again may be pushed or pulled by the exchange mechanism. In a particularly simple alternative, the casing of the battery 9 could act as the exchange member, with the front wall (the side shown closest) used to push the battery 9 in the Y direction, and the far end wall (opposite to the front wall) being used to pull the battery 9 in the opposite direction, depending on the design of the exchange mechanism.

It is also to be understood that the feeders 2 are also provided with similar exchange members, that the feeders 2 may also be pushed or pulled as required by the exchange mechanism.

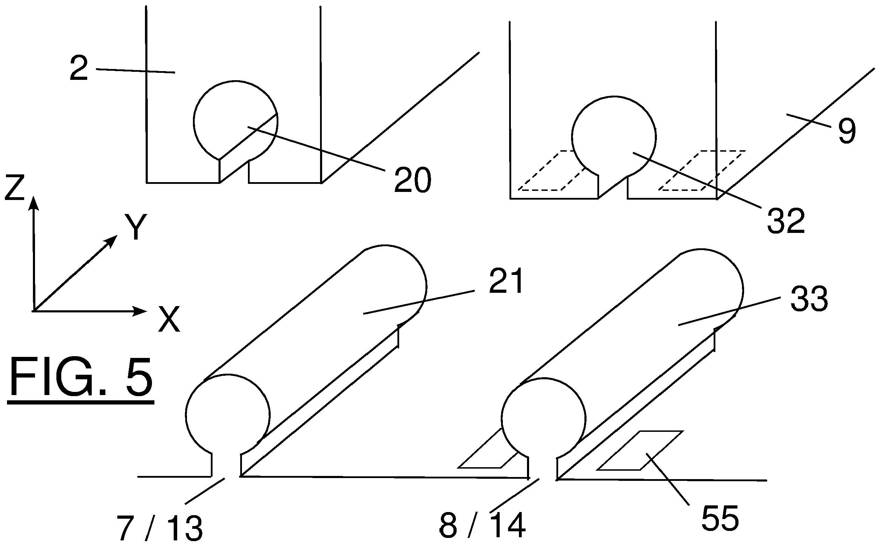

FIG. 5 schematically shows, in perspective view, an expanded view of the engagement means of a feeder 2 and a battery 9, in accordance with another embodiment of the present invention. As shown, the feeder 2 is identical to that of FIG. 3, as is the profiled feeder member 21. However, in this embodiment, the battery 9 includes a profiled battery slot 32 of similar form to the profiled feeder slot 20, and the track 8 / 14 includes a profiled battery member 33 of similar form to the profiled feeder member 21. With such similar profiles, it is possible for a battery 9 to be at least temporarily located on a feeder track 7 / 13, and for a feeder 2 to be at least temporarily located on a battery track 8 / 14. Such an arrangement permits additional flexibility in the system, and optimises usage of spare tracks. For example, a fully-charged battery 9 could be temporarily located on a feeder track 7 / 13 until it is needed, a depleted battery 9 could be temporarily located on a feeder track 7 / 13 until an LSS battery track 13 becomes available, and a feeder could be temporarily located on a battery track 8 / 14 until it is required for use, etc.

FIG. 6 schematically shows, in perspective view, the mobile robot 1 of FIG. 1 with its exchange mechanism 40. For the sake of clarity, the mobile robot 1 is shown without any feeders 2, batteries 9 or any housing that may be present. The exchange mechanism 40 includes a front gantry 41 and a rear gantry 42 that extend above the table 6 parallel to the X axis as shown. The front and rear gantries 41, 42 are supported by upstanding supports 43 projecting upwardly from the table 6. The front gantry 41 carries a front carriage 44 and the rear gantry 42 carries a rear carriage 45, each of which is movable along the length of its respective gantry 41, 42. For example, each of the front and rear gantries 41, 42 may comprise a rotatable screw, rotatable with respect to its supports 43, causing the front and rear carriages to move together along the respective front and rear gantries 41, 42. Alternatively, the front and rear carriages 44, 45 may be independently drivable along the respective front and rear gantries 41, 42 by a linear motor or conventional alternatives. Suspended between the front and rear carriages 44, 45 is a looped belt drive 46, which in turn supports a beam 47, such that the beam 47 and belt drive 46 both extend substantially parallel to the robot feeder tracks 7. An actuator (not shown) is provided to selectively rotate the belt drive 46 either forwards or backwards, which in turn causes movement of the beam 47 parallel to the Y axis shown, in either direction as required. The beam 47 carries a paddle 48 which in use may engage the exchange member of a feeder 2 or battery 9 as required, to effect pushing or pulling thereof. By concerted movement of the beam 47 parallel to the Y axis, and movement of the carriages 44, 45 parallel to the X axis, the paddle 48 may be moved as required within the X-Y plane.

FIGs. 7A-C schematically show, from the side, the exchange mechanism 40 of FIG. 6 in more detail, and in various stages of operation. Looking firstly at FIG. 7A, which shows the exchange mechanism 40 in a retracted configuration such as may be used while the mobile robot 1 is travelling, it can be seen that the beam 47 carries an upper arm 49 and a lower arm 50, both of which are movable relative to the beam 47 in a direction parallel to the Y axis shown. Each of the upper and lower arms 49, 50 comprises a toothed rack which meshingly engages with a toothed wheel 51 pivotably attached to beam 47. Upper arm 49 is held stationary relative to the belt drive 46 by a linkage 52. The paddle 48 is directly suspended from the lower arm 50.

In FIG. 7B, the paddle 48 is moved to an intermediate configuration. This is achieved by moving the beam 47 in the Y direction by driving the belt drive 46. The upper arm 49, which is prevented from moving by the linkage 52, engages with the toothed wheel 51 causing clockwise rotation of the toothed wheel 51, which in turn causes the lower arm 50, with paddle 48, to move in the Y direction relative to the beam 47.

FIG. 7C shows the paddle 49 moved to a fully extended configuration, the beam 47 having been moved fully in the Y direction. It can be seen that using such a double-arm mechanism, the range of travel of the paddle 48 is approximately twice the range of travel of the beam 47. This type of mechanism thereby permits the paddle 48 to be moved outside the footprint of the mobile robot 1, so that feeders or batteries may be fully inserted into, and removed from, the LSS or placement machine as required.

To move the paddle 48 into an exchange member 25, the paddle may be moved next to the feeder 2 or battery 9 and driven until it aligns with the exchange member 25, then moved laterally into the exchange member recess. The process may be performed in reverse to extract the paddle 48 from the exchange member 25.

While in the description above the external battery storage comprises part of an LSS, this is not the only possibility. For example, in some embodiments individual placement machines may comprise the external battery storage, and may themselves be provided with battery charging capabilities.

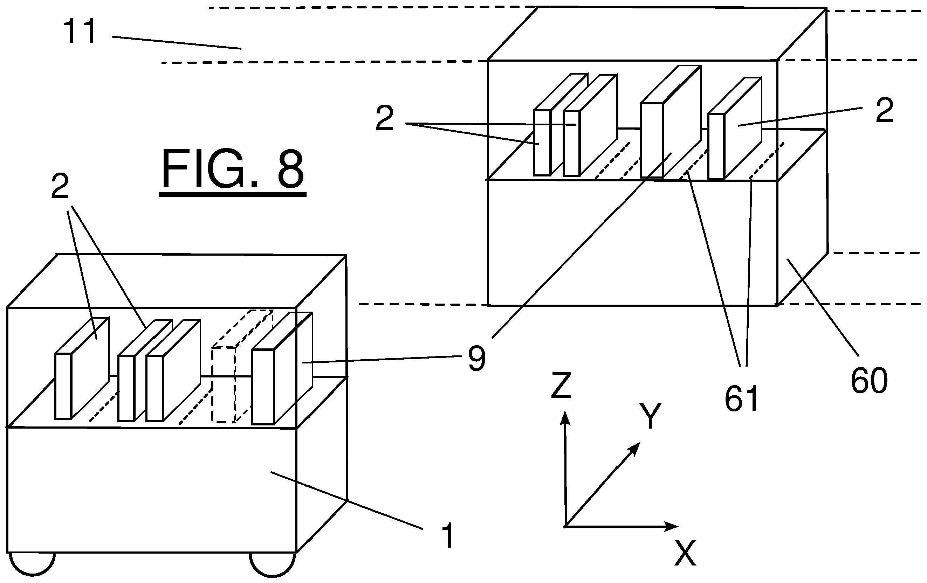

FIG. 8 schematically shows such a placement machine 60 within an SMT production line 11. The placement machine 60 is provided with a plurality of feeder / battery tracks 61 which can accommodate both batteries 9 and feeders 2 - in this embodiment therefore it is essential that the profiled battery and feeder slots and members have similar forms, for example such as shown in FIG. 5. Such a placement machine 60 comprises electrical track contacts (similar to electrical track contacts 55 shown in FIG. 5) at each of the feeder / battery tracks 61, which may be capable of providing power to whichever of a feeder 2 or battery 9 is located within the respective feeder / battery track 61.

Alternatively, a placement machine may be provided with a dedicated charging station, similar to charging stations 3, 15 shown in FIGs. 1 and 2, which is separated from the feeder table of the placement machine.

While equipping placement machines with battery storage capabilities in these ways has the disadvantage that space in the placement machine which could otherwise have been used for feeders is decreased, on the other hand the need for an LSS, or at least an LSS with battery charging station, is reduced, and for certain production lines this may result in an overall more economical system.

The above-described embodiments are exemplary only, and other possibilities and alternatives within the scope of the invention will be apparent to those skilled in the art.

For example, the external battery storage could comprise a separate "buffer" station, where batteries are temporarily stored before being moved to a remote charging station, whether by a mobile robot or otherwise.

### Reference numerals used:

1 - Mobile robot
2 - Feeders
3, 15 - Charging station
4, 16 - Line-side stock station (LSS)
5 - Wheels
6 - Table
7 - Robot feeder track
8 - Robot battery track
9 - Battery
10 - Battery
11 - SMT production line
12 - LSS table
13 - LSS feeder track
14, 14' - LSS battery track
20 - Profiled feeder slot
21 - Profiled feeder member
22, 32 - Profiled battery slot
23, 33 - Profiled battery member
24 - Battery contacts
25 - Exchange member
26 - Upper surface
27, 28 - Internal sidewalls
40 - Exchange mechanism
41 - Front gantry
42 - Rear gantry
43 - Supports
44 - Front carriage
45 - Rear carriage
46 - Belt drive
47 - Beam
48 - Paddle
49 - Upper arm
50 - Lower arm
51 - Toothed wheel
52 - Linkage
55 - Electrical track contacts
60 - Placement machine
61 - Feeder / battery track

## Claims

1. A mobile robot for exchanging feeders with a placement machine, the mobile robot comprising:
a feeder store for temporarily storing feeders,
an exchange mechanism configured to transfer feeders from the feeder store to a placement machine,
a robot electrical contact for receiving electrical power from a modular battery adapted for releasable and repeatable engagement with the mobile robot,
wherein the exchange mechanism is configured to transfer the modular battery to an external battery storage.

2. The mobile robot of claim 1, wherein the exchange mechanism is configured to receive feeders from the placement machine and locate the feeders in the feeder store, and to receive the modular battery from the external battery storage.

3. The mobile robot of either of claims 1 and 2, wherein the feeder store comprises an elongate feeder track in which a respective feeder may be temporarily stored, and the mobile robot comprises at least one elongate battery track arranged parallel to the elongate feeder track in which the modular battery may be temporarily stored.

4. The mobile robot of claim 3, wherein the feeder track and the battery track each comprise a profiled engagement surface for engaging with a feeder and a modular battery respectively; optionally the profiled engagement surfaces of the feeder track and the battery track have the same profile, so that a feeder may engage with the battery track, and a modular battery may engage with the feeder track.

5. The mobile robot of any preceding claim, wherein the exchange mechanism comprises a paddle which is movable along an extension axis away from the mobile robot to push the feeder from the feeder store to the placement machine and the modular battery to the battery storage, and a paddle extension drive operatively connected to the paddle to move the paddle along the extension axis.

6. The mobile robot of claim 5, wherein the paddle is movable along a selection axis orthogonal to the extension axis, to selectively align with the feeder in the feeder store or the modular battery, and the mobile robot comprises a paddle selection drive operatively connected to the paddle to move the paddle along the selection axis.

7. A battery specifically for providing power to a mobile robot configured to transfer feeders to a placement machine, the mobile robot comprising an elongate feeder track in which a respective feeder may be temporarily stored, wherein the battery comprises:
a battery-side engagement means configured to releasably and repeatedly engage with an elongate battery track located on the mobile robot arranged parallel to the elongate feeder track, and
a battery electrical contact for providing electrical power to the mobile robot when the battery-side engagement means is physically engaged with the elongate battery track.

8. The battery of claim 7, wherein the mobile robot is a mobile robot according to claim 1.

9. The battery of claim 8, comprising an exchange member for physically engaging with the exchange mechanism.

10. The battery of any of claims 7 to 9, wherein the battery-side engagement means may physically engage with the elongate feeder track.

11. An SMT production line comprising:
a placement machine,
a mobile robot according to any of claims 1 to 7, and
a charging station for charging a modular battery according to any of claims 8 to 10 for providing power to the mobile robot.

12. The SMT production line of claim 11, wherein the placement machine comprises the charging station.

13. A method of replacing a battery for a mobile robot, the mobile robot operative to exchange feeders with a placement machine and comprising:
a feeder store for temporarily storing feeders, and
an exchange mechanism configured to transfer feeders from the feeder store to a placement machine,
the method comprising the steps of:
i) moving the mobile robot to a battery storage, and
ii) using the exchange mechanism to transfer a depleted battery from the mobile robot to the battery storage.

14. The method of claim 13, comprising the step of:
iii) using the exchange mechanism to transfer a charged battery from the battery storage to the mobile robot, so that an electrical contact of the battery engages with an electrical contact of the mobile robot.

15. The method of either of claims 13 and 14, wherein the mobile robot comprises a mobile robot according to any of claims 1 to 7, and the battery comprises a battery according to any of claims 8 to 10.
